# EUROPÄISCHE PATENTSCHRIFT

(11) **EP 1 573 921 B1**
(45) Veröffentlichungstag und Bekanntmachung des Hinweises auf die Patenterteilung: **05.04.2006**
(21) Anmeldenummer: 03785928.7
(22) Anmeldetag: 23.12.2003
(51) Int. Cl.: H03L 7/189, H03L 7/00, G06F 1/04

(54) **DIGITAL STEUERBARER OSZILLATOR**
DIGITALLY CONTROLLABLE OSCILLATOR
OSCILLATEUR A COMMANDE NUMERIQUE

(30) Priorität: 23.12.2002 DE 10260713
(43) Veröffentlichungstag der Anmeldung: 14.09.2005
(73) Patentinhaber: Infineon Technologies AG, 81669 München (DE)
(72) Erfinder: GRECO, Patrizia, A-9524 St. Magdalen (AT); STEINSCHADEN, Andreas, A-9587 Riegersdorf (AT); THALLER, Edwin, A-9583 Faak/See (AT); ZESSAR, Gernot, A-9531 Kreuth (AT)
(74) Vertreter: Schoppe, Fritz
(86) Internationale Anmeldenummer: PCT/EP2003/014816
(87) Internationale Veröffentlichungsnummer: WO 2004/059847

(56) Entgegenhaltungen:
- EP-A- 0 402 113
- EP-A- 0 824 290
- US-A- 4 568 888
- US-B1- 6 411 237

## Beschreibung

Die vorliegende Erfindung bezieht sich auf steuerbare Oszillatoren und insbesondere auf digital steuerbare Oszillatoren, die zur Taktextraktion, Taktwiedergewinnung, Synchronisation etc. innerhalb oder außerhalb einer Phasenregelschleife einsetzbar sind.

In der Datenübertragungstechnik besteht generell der Bedarf, einen Takt aus einem Datenstrom zu extrahieren. Ein Datenübertragungsstandard, der in letzter Zeit starke Verbreitung erfahren hat, ist der USB-Standard (USB = Universal Serial Bus). Der USB-Standard standardisiert ein Datenübertragungsformat zur schnellen Datenübertragung zwischen USB-Geräten und einem Host. Der USB-Standard definiert eine sogenannte Tier-Star-Topologie, wobei USB-Geräte entweder Hubs oder Funktionen bzw. Funktionsgeräte sein können. Das USB-Datenformat ist in der USB-Spezifikation spezifiziert. Die aktuellste USB-Definition ist gerade USB-Revision 2.0.

Der USB-Bus ist ein Halb-Duplex-Bus. Alle Transaktionen werden von dem Host initiiert. In der USB-Spezifikation-Revision 2.0 sind drei Datenübertragungsraten definiert. Die niedrigste Datenübertragungsrate wird im Low-Speed-Modus verwendet, und beträgt 1,5 Megabit pro Sekunde. Im Full-Speed-Modus wird eine Datenübertragungsrate von 12 Megabit pro Sekunde verwendet. Im High-Speed-Modus wird eine Datenübertragungsrate von 480 Megabit pro Sekunde eingesetzt.

Die Verwendung des Low-Speed-Modus dient für interaktive Geräte, wie z. B. eine Tastatur oder eine Maus. Nur eine begrenzte Anzahl von Low-Speed-Geräten sollte mit dem Bus verbunden sein, um eine Degradation der Bus-Ausnutzung zu vermeiden. Für Full-Speed- und High-Speed-Geräte sind eine spezielle Bandbreite und Latenzzeit garantiert.

Geräte sind mit dem USB-Bus über ein 4-Draht-Kabel verbunden, das Differenzdaten, ein Leistungssignal und Masse trägt. Dies bedeutet; dass eine Ader des 4-Draht-Kabels ein positives . Differenzsignal Dp trägt, dass eine weitere Ader des 4-Draht-Kabels ein negatives Differenzsignal Dn trägt, dass eine weitere Ader auf dem versorgungspotential liegt und dass schließlich die letzte Ader auf dem Massepotential liegt. Die Taktinformationen sind in den Daten codiert. Gemäß der USB-Spezifikation wird eine NRZI-Codierung und eine Bit-Stuffing-Technik verwendet, um eine adäquate Anzahl von Übergängen zu garantieren. NRZI bedeutet No Return to Zero Invert. Dies bedeutet, dass eine inverse Codierung eingesetzt wird. Ein logisches "1"-Signal wird durch eine nicht vorhandene Änderung im elektrischen Signal dargestellt, während ein logisches "0"-Signal durch eine Änderung im Zustand des elektrischen Signals dargestellt wird. Eine Flanke stellt somit eine Null dar, während eine nichtvorhanden Änderung, also ein gleichbleibendes Signal eine Eins darstellt. Ferner wird zur Gleichanteilsreduktion ein Bit-Stuffing eingesetzt, so dass nach sechs aufeinanderfolgenden Einsen eine positive/negative Flanke eingesetzt wird.

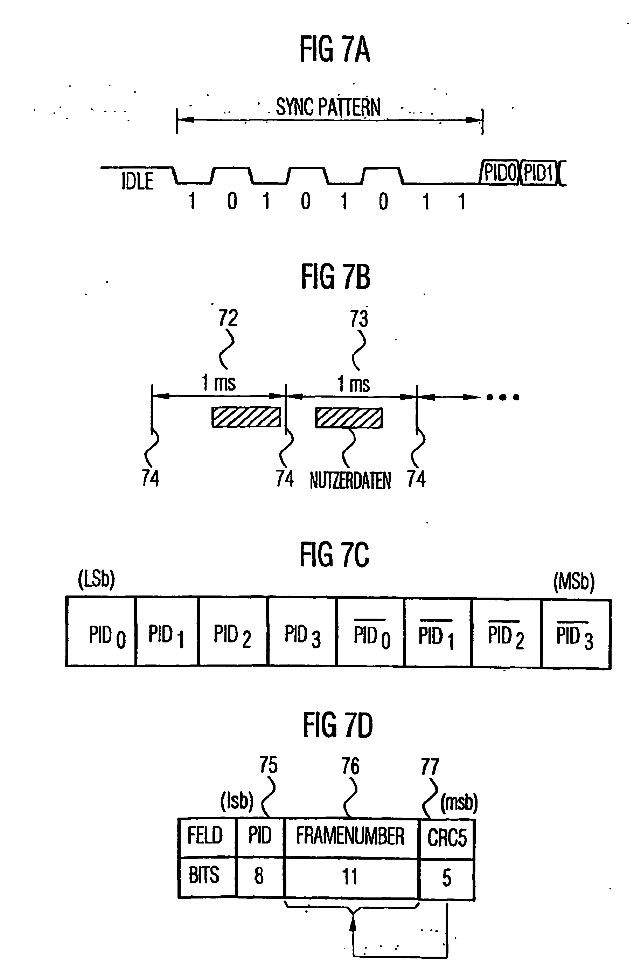

Wie es in Fig. 7b dargestellt ist, ist der Datenstrom als eine Folge von Rahmen oder Frames 72, 73 definiert, die durch sogenannte Kontrollzeichen 74 voneinander getrennt sind, wobei die Ticks in einem Abstand von 1 ms auftreten. Innerhalb des Rahmens 72 oder 73 befindet sich eine Mehrzahl von Datenpaketen. Dies bedeutet, dass ein Rahmen aus mehreren Datenpaketen besteht, und dass sich ein Datenstrom aus einer Mehrzahl aufeinanderfolgender Rahmen zusammensetzt. Jedes Datenpaket wird im Datenstrom von einer Paketidentifikationsnummer eingeleitet, die eine Breite von 8 Bits hat und in Fig. 7c dargestellt ist. Ein Rahmen umfasst daher so viele Paketidentifikationsnummern (PID), wie Pakete in dem Rahmen vorhanden sind. Die in Fig. 7c dargestellte Spezifikation der Paketidentifikationsnummer, die vier Bits breit ist und in einem PID-Feld durch die vier PID-Bits PID₀, PID₁, PID₂, PID₃ und durch die entsprechend invertierten PID-Bits dargestellt ist, ist im USB-Standard festgelegt. Die Bits, die in Fig.7c dargestellt sind, sind vom LSb bis zum MSb angeordnet, LSb steht für niederstwertiges Bit (Least Significant Bit), .während MSb für höchstwertiges Bit (Most Significant Bit) steht.

Der Host überträgt ein Rahmenstart-Paket (SOF-Paket; SOF = Start of Frame) einmal pro Millisekunde, um die in Fig. 7b dargestellten Ticks 74 zu definieren. Das SOF-Paket ist in Fig. 7d dargestellt.und umfasst ein SYNC-Feld (in Fig. 7d nicht dargestellt)., ein SOF-PID-Feld 75, eine 11-Bit-Rahmennummer (76) (Frame Number) sowie eine CRC-Prüfsumme über das Feld 76, die in einem Feld 77 eingetragen ist. Die Rahmennummer 76 wird mit jedem zusätzlichen SOF-Paket um 1 inkrementiert.

In Fig. 7a ist das beispielsweise dem PID-Feld 75 von Fig. 7d vorausgehende Synchronisationsmuster (SYNC-Pattern) als elektrisches Signal dargestellt. Es besteht aus einer im USB-Standard spezifizierten Folge von Bits bzw. einem Datenmuster, das aufgrund der NRZI-Codierung als elektrisches Signal derart aussieht, wie es in Fig. 7a dargestellt ist. Die Folge von Datenbits beträgt 00000001, was zu der in Fig. 7a gezeigten "elektrischen" Folge 10101011 führt. Vor dem Synchronisationsdatenmuster ist ein mit Idle bezeichneter Bereich, der im Hinblick auf die Differenzsignale Dp und Dm eine Single-Ended-Zero (SE0) Codierung aufweist, wie es nachfolgend dargelegt wird. Diese SE0-Codierung der Dp- und Dm-Signale weist auf das Ende eines vorhergehenden Rahmens hin und weist ferner darauf hin, dass nunmehr ein neuer Rahmen folgt, der mit einem Synchronisationsfeld eingeleitet wird, dem unmittelbar, wie es in Fig. 7a gezeigt ist, die Paketidentifikationsnummer und im speziellen, wie es in Fig. 7c gezeigt ist, ein niederstwertiges Bit der PID gefolgt von dem nächsthöherwertigen Bit der PID etc. folgt.

Die in Fig. 7a gezeigte Notation illustriert, dass die Bits im Synchronisationsmuster festgelegt sind und das zugeordnete elektrische Signal die Folge von 10101011 haben kann, während die PID-Bits sowohl eine 0 als auch eine 1 je nach zu codierender Paketidentifikation haben können.

Jedes Low-Speed- oder Full-Speed-Datenpaket, das über den USB-Bus übertragen wird, startet also mit einem Synchronisationsmuster (Fig. 7a), dem die Paket-Identifikationsnummer (PID) folgt, die in Fig. 7c dargestellt ist, welche den Pakettyp definiert. Das Synchronisationsfeld umfasst eine Serie von 0-1-Übergangen auf dem Bus , um es einem Empfänger zu ermöglichen, sich auf den Bittakt zu synchronisieren.

Wie es in Fig. 7 dargestellt ist, ist ein Rahmenintervall von einer Millisekunde definiert. Der Host überträgt ein SOF-Paket (Rahmenstartpaket) einmal pro Millisekunde (Fig. 7b). Das SOF-Paket besteht aus einem Synchronisationsfeld, gefolgt von der SOF-PID, einer 11-Bit-Rahmennummer und einem CRC 5-Fingerabdruck (Fig. 7d). Die Rahmennummer wird mit jedem gesendeten SOF-Paket inkrementiert.

Wenn ein Gerät mit dem USB-Bus verbunden wird, findet eine Hochfahr-Sequenz statt. Am Ende dieser Sequenz wird das Gerät in einen Reset-Zustand getrieben. Nach dem Reset-Ereignis hat das Gerät eine Zeitdauer von 10 Millisekunden, um ein Reset-Recovery durchzuführen. Während dieser Zeit empfängt das Gerät SOF-Pakete.

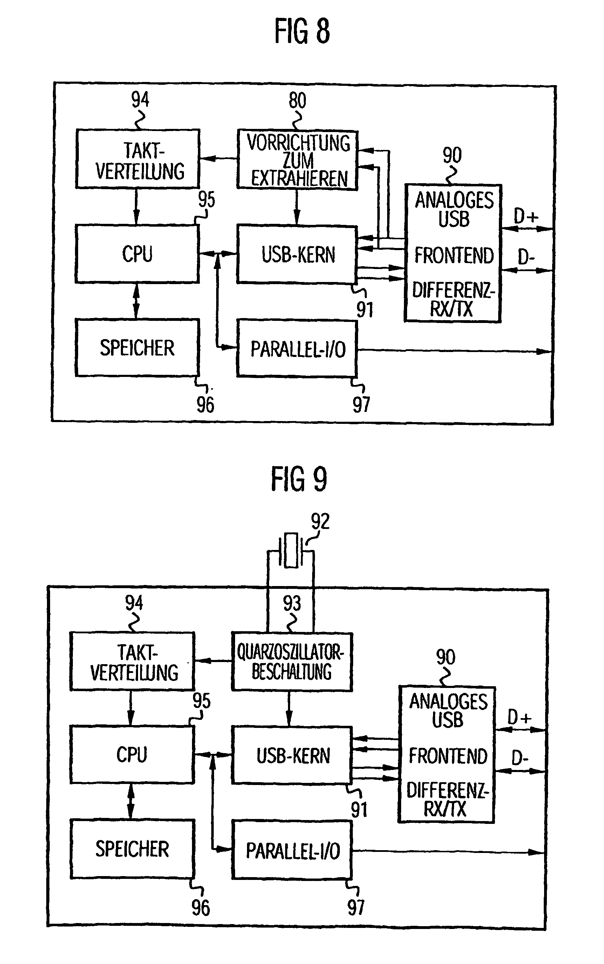

Ein herkömmliches USB-Gerät ist in Fig. 9 schematisch dargestellt. Es umfasst ein analoges USB-Frontend, das mit einem Differenz-Sender (TX) und einem Differenz-Empfänger (RX) in einer Funktionseinheit 90 integriert sein kann. An einer Seite des Elements 90 liegen die Signale Dp und Dm in analoger Form dar, während an einer anderen Seite des Elements 90 die entsprechenden empfangenen und analog/digital gewandelten signale anliegen, die in einen USB-Kern 91 eingespeist werden bzw. von demselben empfangen werden. Diese Signale sind in Fig. 9 durch die zwei Paare von parallelen Signalpfeilen dargestellt. Das USB-Gerät umfasst ferner einen Quarzoszillator 92, der mit einer Quarzoszillatorbeschaltung 93 in Verbindung steht, wobei die Quarzoszillatorbeschaltung 93 einerseits den USB-Kern 91 und andererseits eine Taktverteilung 94 ansteuert, die mit einer CPU 95 verbunden ist, welche wiederum mit einem Speicher 96 in Wirkverbindung steht. Ferner umfasst ein USB-Gerät je nach Anwendung auch eine Parallel-Eingabe-Ausgabe-Schnittstelle (Parallel-I/O) 97.

Solche herkömmlichen USB-Geräte verwenden, wie es aus Fig. 9. ersichtlich ist, typischerweise einen Quarzoszillator 92 als Taktquelle für die Systemgeräte und die USB-Datenwiederherstellungsschaltung. Für robuste tragbare Geräte, wie z. B. Chipkarten, würde es wünschenswert sein, dass sie ihren eigenen lokalen Takt direkt aus dem USB-Datenstrom extrahieren. Für solche Geräte ist die Verwendung von Quarzoszillatoren unpraktisch, da Quarze normalerweise nicht in einen Chip integriert werden können und ferner für eine Zerstörung aufgrund mechanischer Belastungen sehr anfällig sind. Chipkarten werden üblicherweise in rauen Umgebungen getragen, wie z. B. in einem Portemonnaie, das in einer Hosentasche untergebracht ist. Der dadurch ausgeübte mechanische Streß wäre für einen Schwingquarz fatal.

Für Synchronisationsanwendungen im allgemeinen, jedoch auch für andere Zwecke werden digital steuerbare Oszillatoren benötigt. Solche digital steuerbaren Oszillatoren umfassen normalerweise einen steuerbaren Oszillator, der abhängig von einem analogen Eingangssignal eine Schwingung mit einer bestimmten Frequenz erzeugt. Wird das analoge Eingangssignal erhöht oder erniedrigt, so wird typischerweise auch die Frequenz höher oder niedriger. Um eine digitale Steuerbarkeit zu erreichen, wird der Analogeingang des steuerbaren Oszillators mit einem Digital/Analog-Wandler verbunden. Durch Eingeben eines digitalen Wertes in den Digital/Analog-Wandler wird ein bestimmtes analoges Ausgangssignal erzeugt, das von dem Digitaleingangssignal abhängt.

Nachteilig an einem solchen digital steuerbaren Oszillator ist, dass der Digital/Analog-Wandler immer auf eine bestimmte Bitbreite beschränkt ist, die einem Signalhub des analogen Ausgangssignals zugeordnet ist, welcher letztendlich die Aussteuerbarkeit des steuerbaren Oszillators bestimmt. Steuerbare Oszillatoren haben typischerweise eine untere Frequenz, die beispielsweise dann erreicht wird, wenn als Binärwort in den Digital/Analog-Wandler lauter Nullen eingegeben. werden. Die höchste Frequenz des steuerbaren Oszillators wird erreicht, wenn als binäres Wort in den Digital/Analog-Wandler lauter Einsen eingegeben werden. Die binäre Gewichtung, die Digital/Analog-Wandler im allgemeinen haben, und die Anforderung, dass ein Digital/Analog-Wandler ein maximales Ausgangssignal und ein minimales Ausgangssignal erzeugen muss, die an den Aussteuerbereich des Oszillators angepasst sind, die also so gewählt sein müssen, dass einerseits die minimale Frequenz des steuerbaren Oszillators und andererseits die maximale Frequenz des steuerbaren Oszillators erzielt werden, ergeben automatisch ein Konsequenz hinsichtlich der Quantelung der Frequenz bzw. der Granularität der Frequenzeinstellung.

Die Quantisierung bzw. Quantelung der Frequenzeinstellung ist festgelegt, also die minimale Schrittweite, um die das analoge Ausgangssignal des Digital/Analog-Wandlers, das gleichzeitig das analoge Eingangssignal in den steuerbaren Oszillator ist, und damit die Frequenz des Oszillators variiert werden kann.

Wird das binäre Eingangswort in den Digital/Analog-Wandler um ein digitales Inkrement erhöht, so ergibt sich am Ausgang des Digital/Analog-Wandlers eine Differenz in dem analogen Ausgangssignal, die dazu führt, dass die Frequenz des steuerbaren Oszillators um einen bestimmten Betrag steigt. Beispielhaft ausgedrückt ergibt sich somit folgende Situation. Wird ein binäres Eingangswort von beispielsweise 1000 in den Digital/Analog-Wandler um ein digitales Inkrement, also um eine Änderung des niederstwertigen Bits (LSB) erhöht, wird also statt 1000 der binäre wert 1001 eingegeben, so ist das analoge Ausgangssignal um einen bestimmten Differenzwert δs hoher; was dazu führt, dass die Frequenz des steuerbaren Oszillators wiederum um einen bestimmten Frequenzdifferenzwert δf ansteigt oder abfällt.

Diese Quantisierung könnte in manchen Fällen zu grob sein, insbesondere wenn an Synchronisationsschaltungen gedacht wird, bei denen sehr geringe Frequenzäriderungen erforderlich sind, da eine sehr genaue Synchronisation erwünscht wird.

Die DE 10041772 C2 offenbart einen Taktgenerator insbesondere für USB-Geräte, bei dem aufgrund eines periodisch im Datenstrom wiederkehrenden Synchronisationssignals ein Pulsfilter angesteuert wird, um eine Frequenz eines Pulszuges, der von einem internen Taktgenerator ausgegeben wird, durch Unterdrücken von Pulsen in der effektiven Frequenz zu reduzieren. Ferner wird unter Verwendung des Synchronisationssignals und eines in einem Pulszahlspeicher abgelegten Werts bzw. unter Verwendung eines Ausgangssignals eines Datensignaldecodierers eine von dem internen Taktgenerator erzeugte Frequenz nachgestimmt.

Um diesen Differenzwert zu erhöhen, könnte entweder die Breite des Digital/Analog-Wandlers erhöht werden, derart, dass derselbe einen größeren Bereich von darstellbaren Zahlen erhält. Dies ist jedoch in manchen Anwendungen nicht erwünscht, da Digital/Analog-Wandler insbesondere bei integrierten Schaltungen vom Layout/Design vorgegeben sind. Andererseits könnte der Digital/Analog-Wandler hinsichtlich seiner Versorgungs- bzw. Referenzspannung reduziert werden, derart, dass das maximale binäre Wort zu einem geringeren maximalen Ausgangssignal führt, und damit natürlich auch zu einem geringeren δf für ein digitales Frequenzinkrement, Diese Option hat jedoch den Nachteil, dass dann nicht mehr der maximale Aussteuerbereich des steuerbaren Oszillators genutzt werden kann, was insbesondere dann von Nachteil ist, wenn Anwendungen vorliegen, bei denen große Frequenzänderungen systembedingt sind. Solche SzenarIen finden sich beispielsweise bei Frequenz-Hopping-Anwendungen.

Die US 6 411 237 zeigt einen digital steuerbaren Oszillator gemäß dem Oberbegriff von Anspruch 1.

Die Aufgabe der vorliegenden Erfindung besteht darin, einen flexibleren digital steuerbaren Oszillator zu schaffen.

Diese.Aufgabe wird durch einen digital steuerbaren Oszillator nach Patentanspruch 1 gelöst.

Die vorliegende Erfindung liegt die Erkenntnis zugrunde, dass das analoge Eingangssignal in den steuerbaren Oszillator nicht mehr unter Verwendung eines einzigen Digital/Analog-Wandlers erzeugt wird, sondern zumindest unter Verwendung zweier Digital/Analog-Wandler, die beide ein analoges Ausgangssignal liefern, die an einem Kombinierer kombiniert werden, um ein resultierendes DAW-Ausgangssignal zu erhalten, das in den steuerbaren Oszillator bzw. eine Schwingungserzeugungseinrichtung eingespeist wird. Um eine höhere Flexibilität zu erreichen, ist einer der beiden Digital/Analog-Wandler ausgebildet, um ansprechend auf ein digitales Inkrement in einem digitalen Eingangssignal eine Differenz in dem Digital/Analog-Wandler-Ausgangssignal dieses Wandlers zu erzeugen, das kleiner ist als eine Differenz in dem Ausgangssignal des anderen Digital/Analog-Wandlers, wenn der andere Digital/Analog-Wandler mit dem vorzugsweise gleichen digitalen Inkrement beaufschlagt wird.

In anderen Worten ausgedrückt erlaubt das erfindungsgemäße Konzept, dass ein Digital/Analog-Wandler, nämlich der, der die größere Differenz in seinem Ausgangssignal auf ein digitales Inkrement liefert, die Ausnutzung des gesamten Aussteuerbereichs des steuerbaren Oszillators. Damit einhergehend ist die Quantisierung dieses Digital/Analog-Wandlers relativ grob. Erfindungsgemäß wird dieser Nachteil jedoch dadurch behoben, dass ein zweiter Digital/Analog-Wandler vorgesehen wird, der eine feinere Quantisierung hat als der erste Digital/Analog-Wandler, so dass gewissermaßen eine Grobabstimmung mit dem ersten Digital/Analog-Wandler erreichbar ist, während eine Feinabstimmung dann durch Änderung des digitalen Eingangssignals in den zweiten Digital/Analog-Wandler erreicht werden kann. Je nach Anwendungsform kann das Quantisierungsintervall bzw. die Differenz im Ausgangssignal des zweiten Digital/Analog-Wandlers beliebig klein gemacht werden.

Dies kann dadurch geschehen, dass der zweite Digital/Analog-Wandler mit einem Strom aus einer eigenen Stromquelle versorgt wird, die von der Stromquelle zur Versorgung des ersten Digital/Analog-Wandlers getrennt angeordnet ist.

Bei einem bevorzugtem Ausführungsbeispiel der vorliegenden Erfindung wird jedoch die Bereichseinstellung des zweiten Digital/Analog-Wandlers durch Bereitstellen eines dritten Digital/Analog-Wandlers erreicht, welcher ausgangsseitig das Versorgungssignal für den zweiten Digital/Analog-Wandler liefert. Durch Eingeben eines digitalen Wertes in den dritten Digital/Analog-Wandler kann dann bequem und flexibel der Aussteuerbereich des zweiten Digital/Analog-Wandlers und damit die Differenz im Ausgangssignal des zweiten Digital/Analog-Wandlers bei Anlegen eines digitalen Inkrements an denselben flexibel und beliebig fein gesteuert werden. Das Bereitstellen eines dritten Digital/Analog-Wandlers ermöglicht es ferner, dass zwei der drei Digital/Analog-Wandler von der selben Quelle versorgt werden, was insbesondere für integrierte Anwendungen vorteilhaft ist, bei denen nicht beliebig viele Quellen zur Verfügung stehen. Außerdem muss keine Verlustleistung durch Strom/Spannungsteiler hingenommen werden.

Bei einem bevorzugtem Ausführungsbeispiel der vorliegenden. Erfindung.wird als Schwingungserzeugungseinrichtung eine vollständig integrierbare Form ohne Schwingquarze bevorzugt, wie z.B. eine Kette mit einer ungeraden Anzahl von Invertern, die von dem resultierenden Digital/Analog-Wandler-Ausgangssignal am Ausgang des Kombinierers versorgt werden und abhängig von dem Wert dieses Signals eine andere Schwingungsfreqüenz erzeugen.

Der digital steuerbare Oszillator gemäß der vorliegenden Erfindung ist in seiner Ansteuerung flexibel einerseits hinsichtlich des maximalen Aussteuerbereichs und andererseits hinsichtlich des kleinsten erzeugbaren Frequenzinkrements und kann daher in nahezu beliebigen Einsatzbereichen angewendet werden.

Der erfindungsgemäße Oszillator ist besonders für Taktextraktionsanwendungen auch für schnellere USB-Modi geeignet. Hier ist das Synchronisationsfeld alleine bzw. die Zeitdauer des Synchronisationsfelds wenigstens ausreichend ist, um eine Grobeinstellung eines in Grenzen freilaufenden Oszillators zu erreichen. Die damit erreichbare Genauigkeit für die Einstellung des freilaufenden Oszillators ist jedoch, viel zu gering, um eine sinnvolle Datenextraktion durchzuführen. Sie ist jedoch bereits ausreichend genau, um mit einer Grob-Datenwiedergewinnung zu starten, um das Paketidentifikationsfeld, das auf das Synchronisationsfeld folgt, zu decodieren. Es wird die Anzahl von Taktperioden des freilaufenden Oszillators zwischen zwei zeitlich aufeinanderfolgenden Paketidentifikationsfeldern gezählt und mit einem vorbestimmten Referenzwert verglichen.

Die Taktextraktion basiert somit darauf, dass, obgleich ein Zeit-Jitter für aufeinanderfolgende USB-Takte von 12 ns bzw. 20 ns zugelassen ist, die Genauigkeit für ein Rahmenintervall, also für den Abstand zwischen zwei aufeinanderfolgenden Rahmenstart-Paketidentifikationen prozentual gesehen wesentlich enger vorgegeben ist. So ist beim USB-Standard ein Rahmenintervall auf 1 ms ±500 ns definiert. Dies entspricht einer relativen Genauigkeit von 0,05%. Es wird daher die mit hoher relativer Genauigkeit vorliegende Rahmenperiode verwendet, um eine Feineinstellung des Taktwiedergewinnungsoszillators zu erreichen.

An dieser Stelle sei darauf hingewiesen, dass die Feinabstimmung auf der Basis der Rahmenperiode, also dem ersten Datenmuster bei einem bevorzugten Ausführungsbeispiel erst erfolgt, nachdem die Grobabstimmung auf der Basis des Synchronisationsfelds stattgefunden hat, da bei dem bevorzugten Ausführungsbeispiel eine Rahmenidentifikationsnummerndecodierung gut funktioniert, nachdem eine Grobabstimmung stattgefunden hat.

Das Extraktionskonzept ist dahingehend vorteilhaft, dass eine zweischrittige Vorgehensweise angewandt wird, bei der die Feinabstimmung auf der Grobabstimmung aufbaut und damit ohne externe Schwingquarze oder aufwendige nicht-integrierbare Resonatoren eine Taktwiedergewinnung auch für Geräte ermöglicht, die mit schnellen Datenraten arbeiten, wie z. B. dem USB-High-Speed-Modus oder USB-Full-Speed-Modus.

Das Extraktionskonzept ist ferner dahingehend vorteilhaft, dass der Einsatz einfacher und damit robust arbeitender Algorithmen möglich ist, so dass eine einfache und gleichzeitig robuste Implementierung z. B. auf tragbaren Geräten wie Chipkarten etc. möglich ist, die auch hinsichtlich der Rechenleistung und hinsichtlich des Speicherbedarfs per se begrenzt sind.

Es wird somit auf der Basis eines in dem Datenstrom vorhandenen zweiten Datenmusters, das vorzugsweise einfach detektierbar ist, eine Grobabstimmung vorgenommen, und wird auf der Basis von in dem Datenstrom wiederkehrenden ersten Datenmustern eine Feinabstimmung durchgeführt, wobei die wiederkehrenden ersten Datenmuster mit hoher Genauigkeit vorliegen, jedoch nicht derart einfach detektierbar sind wie ein zweites Datenmuster. Damit wird eine Taktwiedergewinnung mit der hohen Genauigkeit, die dem wiederkehrenden ersten Datenmuster in dem Datenstrom zugrunde liegt, erreicht, zu dessen Detektion jedoch eine Grobabstimmung des Oszillators auf der Basis des zwar einfach detektierbaren jedoch ungenau vorliegenden zweiten Datenmusters verwendet wird.

Bevorzugte Ausführungsbeispiele der vorliegenden Erfindung werden nachfolgend Bezug nehmend auf die beiliegenden Zeichnungen detailliert erläutert. Es zeigen:
- Fig. 1: ein Blockdiagramm einer Vorrichtung zum Extrahieren einer einem Datenstrom zugrundeliegenden Taktfrequenz;
- Fig. 2: ein detailliertes Blockdiagramm der Grobabstimmungseinrichtung von Fig. 1;
- Fig. 3: ein detailliertes Blockdiagramm der Feinabstimmungseinrichtung von Fig. 3;
- Fig. 4: ein Blockschaltbild des Konzepts zum iterativen Grob- bzw. Feinabstimmen;
- Fig. 5: ein Blockschaltbild einer Vorrichtung zum Extrahieren mit einem erfindungsgemäßen digital steuerbaren Oszillator;
- Fig. 6: ein Flußdiagramm zur Erläuterung des bei dem in Fig. 5 Beispiels verwendeten Iterationsverfahrens;
- Fig. 7a: einen Ausschnitt des Datenstroms mit Synchronisationsmuster und nachfolgendem PID-Muster;
- Fig. 7b: eine Darstellung der Organisation des Datenstroms in Frames;
- Fig. 7c: eine Darstellung der in dem Datenstrom enthaltenen PID gemäß dem USB-Standard;
- Fig. 7d: eine Darstellung der Rahmenstart-PID gemäß dem USB-Standard;
- Fig. 8: ein Blockschaltbild eines USB-Geräts mit einer Vorrichtung zum Extrahieren; und
- Fig. 9: ein Blockschaltbild eines USB-Geräts mit einem externen Quarzoszillator.

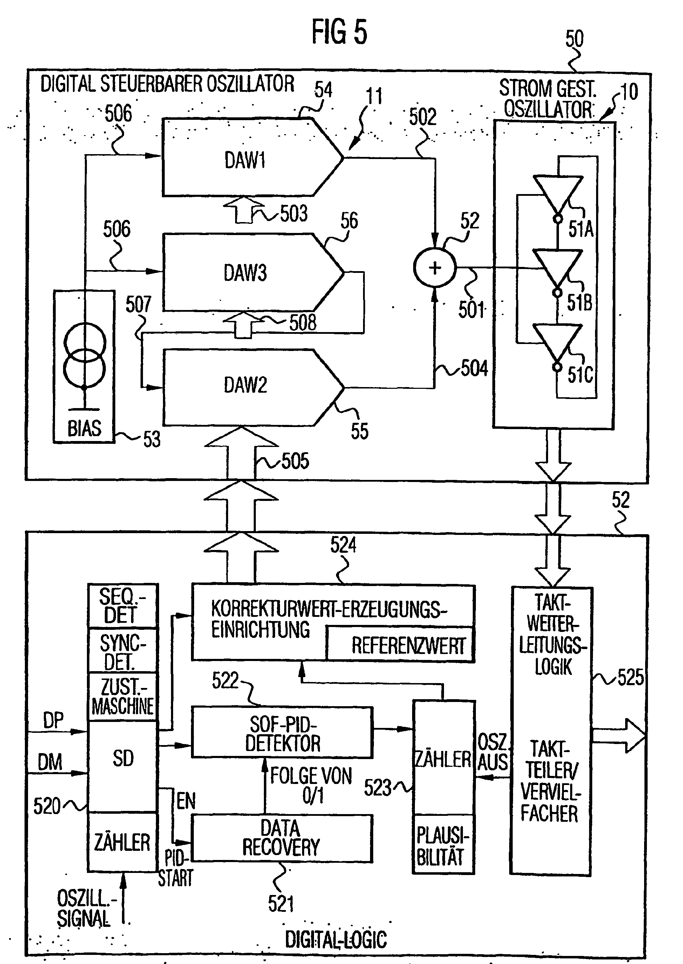

Fig. 5 zeigt unter dem Bezugszeichen 50 einen digital steuerbaren Oszillator gemäß einem bevorzugten Ausführungsbeispiel der vorliegenden Erfindung. Der digital steuerbare Oszillator umfasst eine Schwingungserzeugungseinrichtung 10, die ausgebildet ist, um eine Schwingung zu erzeugen, die eine Frequenz hat, die über ein analoges Eingangssignal in die Schwingungserzeugungseinrichtung einstellbar ist. Das analoge Eingangssignal in die Schwingungserzeugungseinrichtung ist mit 501 in Fig. 5 dargestellt.

Der digital steuerbare Oszillator umfasst ferner eine oszillatorsteuerung 11 zum Erzeugen des analogen Eingangssignals, wobei die Oszillatorsteuerung einen ersten Digital/Analog-Wandler 54 zum Liefern eines ersten Digital/Analog-Wandler-Ausgangssignals 502, ansprechend auf ein erstes digitales Eingangssignal 503 aufweist. Die Oszillatorsteuerung 11 umfasst ferner einen zweiten Digital/Analog-Wandler 55 zum Liefern eines zweiten Digital/Analog-Wandler-Ausgangssignals 504, ansprechend auf ein zweites digitales Eingangssignal 505.

Die Oszillatorsteuerung 11 umfasst ferner einen Kombinierer 52 zum Kombinieren des ersten und des zweiten Digital/Analog-Wandler-Ausgangssignals 502, 504, um das analoge Eingangssignal 501 für die Schwingungserzeugungseinrichtung zu erhalten. Erfindungsgemäß ist der zweite Digital/Analog-Wandler 55 ausgebildet, um ansprechend auf ein digitales Inkrement in seinem Eingangssignal 505 eine Differenz in dem zweiten Digital/Analog-Wandler-Ausgangssignal 504 zu liefern, die kleiner ist als eine Differenz in dem ersten Digital/Analog-Wandler-Ausgangssignal 502, wenn der erste Digital/Analog-Wandler mit dem digitalen Inkrement in seinem digitalen Eingangssignal 503 beaufschlagt wird.

Wie es in Fig. 5 gezeigt ist, werden der erste und der zweite Digital/Analog-Wandler 54 und 55 durch ein Versorgungssignal 506 bzw. 507 versorgt.

Bei einem bevorzugtem Ausführungsbeispiel der vorliegenden Erfindung wird das Versorgungssignal für den zweiten Digital/Analog-Wandler 55 von einem dritten Digital/Analog-Wandler 56 erzeugt, in dem der dritte Digital/Analog-Wandler 56 mit einem bestimmten dritten digitalen Eingangssignal 508 beaufschlagt wird. Wie es in Fig. 5 gezeigt ist, wird der dritte Digital/Analog-Wandler 56 mit dem selben Versorgungssignal 506 beaufschlagt wie der erste Digital/Analog-Wandler 54.

Im nachfolgenden wird eine bevorzugte Anwendung des erfindungsgemäßen digital steuerbaren Oszillators in einer Vorrichtung und einem Verfahren zum Extrahieren einer einem-Datenstrom zugrundeliegenden Taktfrequenz und insbesondere zum Wiedergewinnen dieser Taktfrequenz dargelegt.

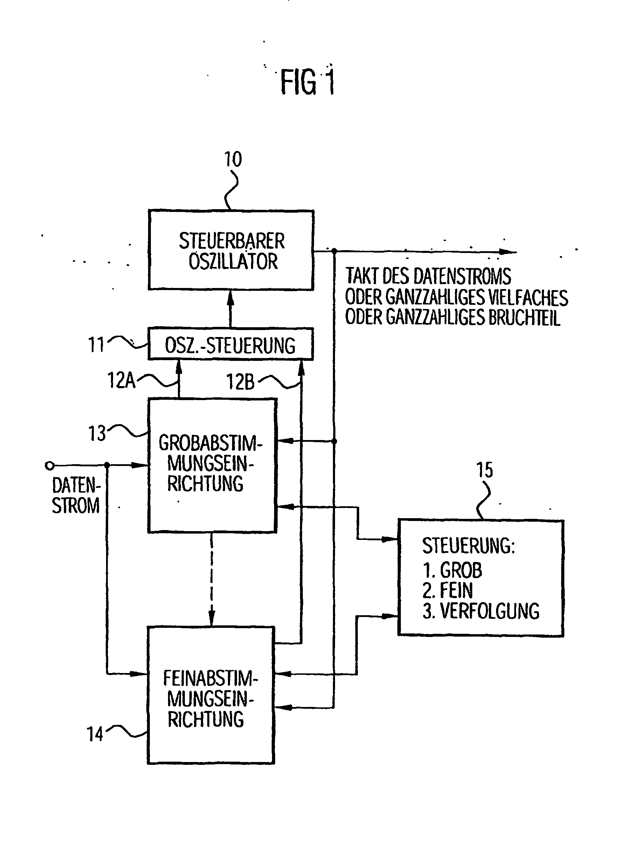

Fig. 1 zeigt eine Vorrichtung zum Extrahieren einer einem Datenstrom zugrundeliegenden Taktfrequenz, wobei der Datenstrom in regelmäßigen, mit einer relativen ersten Genauigkeit spezifizierten ersten zeitlichen Abständen, wie z. B. 1 ms bei einer Anwendung für einen USB-Datenstrom, ein erstes Datenmuster, wie.z. B. eine Rahmenstart-Paketidentifikationsnummer (SOF-PID) aufweist, und wobei der Datenstrom ferner ein zweites Datenmuster (Synchronisations-Feld) aufweist, das eine Mehrzahl von Taktperioden gemäß der Taktfrequenz oder einem Vielfachen der Taktfrequenz aufweist, wobei die Taktperioden mit einer zweiten relativen Genauigkeit spezifiziert sind, die kleiner als die erste relative Genauigkeit ist.

Die Vorrichtung ist ausgebildet, um einen erfindungsgemäßen steuerbaren Oszillator 10 anzusteuern, d. h. um eine Oszillator-Steuerung 11 desselben mit Grobabstimmungssignalen auf einer Leitung 12a oder Feinabstimmungssignalen auf einer Leitung 12b zu beliefern, derart, dass die Oszillatorsteuerung 11 dem steuerbaren Oszillator 10 je nach Ausführung des steuerbaren Oszillators ein entsprechendes Spannungssignal im Falle eines VCO oder ein entsprechendes Stromsignal im Falle eines ICO zuführen kann.

Die Vorrichtung umfasst eine Grobabstimmungseinrichtung 13 und eine Feinabstimmungseinrichtung 14. Die Grobabstimmungseinrichtung ist ausgebildet, um einen Beginn und ein Ende des zweiten Datenmusters (Synchronisationsfeld am Beispiel der USB-Spezifikation) zu detektieren. Die Grobabstimmungseinrichtung ist ferner ausgebildet, um eine Anzahl von Taktperioden des steuerbaren Oszillators 10 in einer Zeitdauer von dem Beginn zu dem Ende des zweiten Datenmusters zu zählen. Darüber hinaus ist die Grobabstimmungseinrichtung ausgebildet, um in dem Fall, in dem die gezählte Anzahl größer als ein Referenzwert ist, die Einrichtung 11 zur Oszillatorsteuerung anzusteuern, um die Oszillatortaktfrequenz des steuerbaren Oszillators 10 zu verringern, oder in dem Fall, in dem die gezählte Anzahl kleiner als der Referenzwert ist, den steuerbaren Oszillator anzusteuern, um dessen Oszillatortaktfrequenz zu erhöhen.

Analog hierzu ist die Feinabstimmungseinrichtung 14 ausgebildet. Im Unterschied zur Grobabstimmungseinrichtung detektiert sie jedoch nicht den Beginn und das Ende des zweiten Datenmusters sondern das Auftreten eines ersten Datenmüsters im Datenstrom und ein zeitlich folgendes Auftreten des ersten Datenmusters im Datenstrom.

Die Feinabstimmungseinrichtung ist ferner ausgebildet, um die Anzahl von Taktperioden des Oszillators 10 von einem Auftreten des ersten Datenmusters bis zu einem nächsten Auftreten des ersten Datenmusters zu zählen, um dann je nach Lage des gezählten Werts bezüglich eines eingestellten Referenzwerts die Oszillatorsteuerungseinrichtung 11 anzusteuern, damit die Schwingfrequenz des steuerbaren Oszillators 10 erhöht bzw. erniedrigt wird.

Dadurch wird eine Oszillatortaktfrequenz mit der relativen zweiten Genauigkeit, also der Genauigkeit, die dem ersten Datenmuster zugrunde liegt, erhalten, die, je nach spezifischer Ausführung, unmittelbar gleich dem Takt ist, der dem Datenstrom zugrunde liegt, oder gleich einem Vielfachen des Takts ist, der dem Datenstrom zugrunde liegt, oder gleich einem Bruchteil des Takts ist, der dem Datenstrom zugrunde liegt. Insbesondere werden ganzzahlige Vielfache, wie z. B. das Zweifache, Dreifache, .... n-fache bevorzugt, wobei n eine ganze Zahl ist. Bezüglich der Bruchteile werden ebenfalls ganzzahlige Bruchteil bevorzugt, wie z. B. 1/2, 1/3, 1/4, ...., 1/n, wobei n ebenfalls eine ganze Zahl ist.

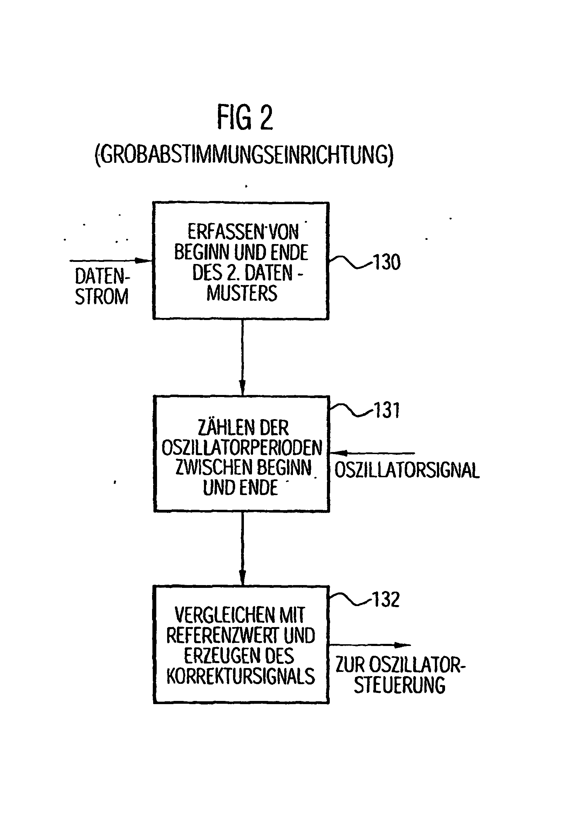

Fig. 2 zeigt ein detaillierteres Blockdiagramm der Grobabstimmungseinrichtung von Fig. 1. Im einzelnen umfasst die Grobabstimmungseinrichtung 13 von Fig. 1 eine Einrichtung 130 zum Erfassen des Beginns und des Endes des zweiten Datenmusters im Datenstrom, also am Beispiel des USB-Datenstroms z. B. den Beginn des Synchronisationsmusters in Form der ersten elektrischen "1" und das Ende des Synchronisationsmusters in Form der letzten elektrischen "1" des Synchronisationsmusters von Fig. 7a. In Ausführungsform und Implementation kann jedoch auch nur ein Teil des Synchronisationsmusters von Fig. 7a als zweites Datenmuster verwendet werden, so dass das zweite Datenmuster, das zu Grobabstimmungszecken verwendet wird, mit der ersten elektrischen "1" beginnt und mit der siebenten logischen "0" endet, derart, dass nur der alternierende Teil des Synchronisationsmusters von Fig. 7a verwendet wird. Wieder alternativ könnte auch lediglich abhängig von dem Verhältnis der Frequenz des steuerbaren Oszillators zu dem in Fig. 7a verwendeten Bittakt auch nur ein Teil des alternierenden Bitmusters eingesetzt werden.

Ansprechend auf die Einrichtung 130 wird eine Einrichtung 131 zum Zählen der Oszillatorperioden zwischen dem von der Einrichtung 130 erfassten Beginn und dem von der Einrichtung 130 erfassten Ende betrieben. Im einzelnen wird durch ein Zähleraktivierungssignal, das die Einrichtung 130 ausgibt, wenn sie den Beginn des zweiten Datenmusters detektiert hat, ein Zähler gestartet, der die Taktperioden des der Einrichtung 131 zugeführten Oszillatorsignals so lange zählt, bis von der Einrichtung 130 das Ende erfasst wird oder entsprechend das Zähler-Stop-Signal von der Einrichtung 130 zu der Einrichtung 131 übermittelt wird.

Der Zählerstand kann dann von der Einrichtung 131 einer Einrichtung 132 zugeführt werden, die ausgebildet ist, um den Zählerstand mit einem Referenzwert zu vergleichen, und um ein entsprechendes Korrektursignal zu liefern, das zur Oszillatorsteuerung (Einrichtung 11 von Fig. 1) übermittelt wird. Der von der Einrichtung 132 verwendete Referenzwert hängt von einer Nennfrequenz des Oszillators 10 und einer zeitlichen Dauer bzw. Anzahl von betrachteten Bits des in Fig. 7a dargestellten Synchronisationsmusters oder eines Teils desselben ab. Beträgt der Bittakt des Synchronisationsmusters in Fig. 7a z. B. 12 Megabit pro Sekunde im Full-Speed-USB-Modus, und liegt die Nennfrequenz des steuerbaren Oszillators beispielsweise bei 96 MHz, also dem achtfachen des Full-Speed-USB-Takts, und wird das gesamte Synchronisationsfeld, also die 8 Bittakte zur Grobabstimmung verwendet, so wird in diesem Fall der vorbestimmte Referenzwert gleich 64 sein. Dies bedeutet, dass im Falle einer optimalen Oszillatoreinstellung der steuerbare Oszillator 10 während der Dauer des Synchronisationsmusters von Fig. 7a 64 Takte liefern müsste. Liefert er weniger als 64 Takte, so ist er zu langsam. Liefert.er dagegen mehr als 64 Takte, so ist zu schnell.

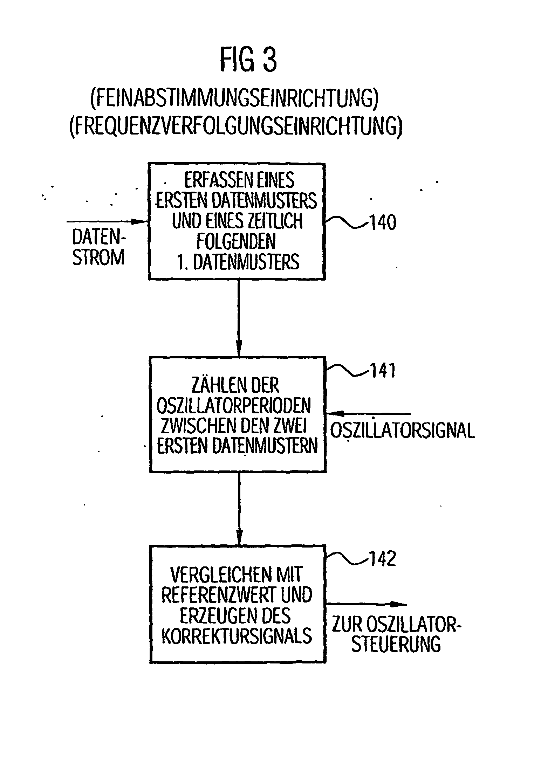

Fig. 3 zeigt ein detaillierteres Blockdiagramm der Feinabstimmungseinrichtung 14 von Fig. 1. Die Feinabstimmungseinrichtung 14 von Fig. 1 umfasst eine Einrichtung 140 zum Erfassen eines ersten Datenmusters (einer SOF-PID am Beispiel des USB-Formats) und eines zeitlich folgenden ersten Datenmusters. Beim Erfassen eines ersten Datenmusters wird ein Zähler in einer Einrichtung 141 zum Zählen der Oszillatorperioden bei einem ersten Datenmuster aktiviert, der dann, wenn ein zeitlich folgendes erstes Datenmuster detektiert worden ist, wieder angehalten wird. Der Zähler in der Einrichtung 141 ist wirksam, um die Taktperioden des steuerbaren Oszillators 10 von Fig. 1 zu zählen. Der Zählwert wird dann einer Einrichtung 142 zugeführt, die ausgebildet ist, um diesen Zählwert mit einem Referenzwert zu vergleichen und das Korrektursignal zu erzeugen, das der Oszillatorsteuerung 11 von Fig. 1 zugeführt wird.

Am Beispiel eines USB-spezifizierten Datenstroms ist der zeitliche Abstand zwischen zwei aufeinanderfolgenden ersten Datenmustern 1 ms, wie es in Fig. 7b gezeigt ist. Beträgt die Nennfrequenz des steuerbaren Oszillators 10 von Fig. 1 wieder 96 MHz, so wäre in diesem Fall der vorbestimmte Referenzwert 96.000, d. h. es müssten 96.000 Oszillatorzyklen in dem Zeitraum von 1 Millisekunde auftreten, damit der Oszillator korrekt eingestellt ist. Ist der Zählwert größer als 96.000, so muss die Oszillatorfrequenz reduziert werden. Ist der Zählwert dagegen kleiner als 96.000, so muss die Oszillatorfrequenz erhöht werden.

Die in Fig. 3 gezeigte Feinabstimmungseinrichtung kann ferner als Frequenzverfolgungseinrichtung eingesetzt werden, nachdem sowohl die Grobabstimmung als auch die Feinabstimmung beendet sind und die Genauigkeit bzw. die Frequenzfolgefähigkeit des Oszillators weiter gesteigert werden soll, wie es nachfolgend noch erläutert wird.

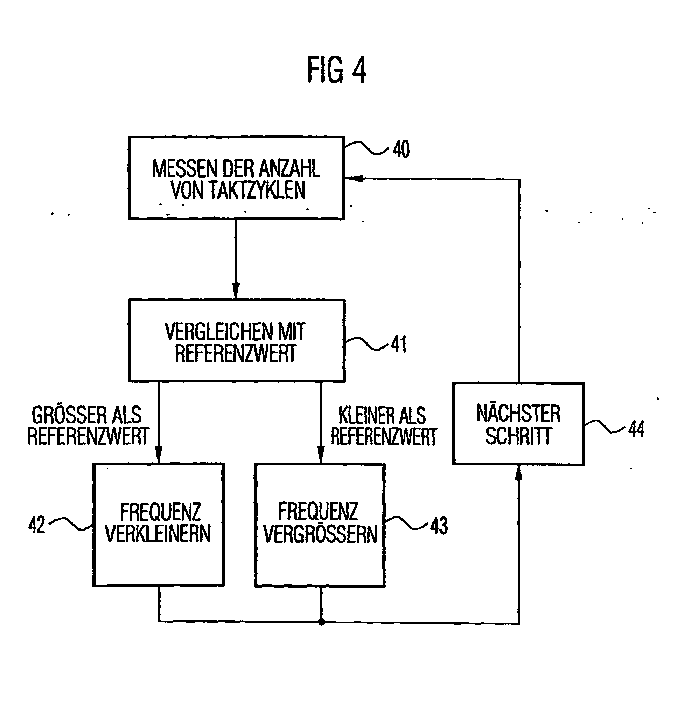

Die Einrichtungen 132 von Fig. 2 bzw. 142 von Fig. 3 sind vorzugsweise ausgebildet, um iterativ zu arbeiten, wie es anhand von Fig. 4 nachfolgend erläutert wird. Die iterative Vorgehensweise besteht darin, zunächst die Anzahl der Taktzyklen durch die Einrichtungen 130 bzw. 140 zu messen (40), um die gemessene Anzahl dann mit einem Referenzwert zu vergleichen (41). Ist das Vergleichsergebnis dahingehend, dass die Anzahl von Taktzyklen größer als der Referenzwert ist, so wird die Frequenz verkleinert (42). Wird dagegen festgestellt, dass die gemessene Anzahl von Taktzyklen kleiner als der Referenzwert ist, so muss die Frequenz des Oszillators vergrößert werden (43). Dann wird eine Iterationsvariable inkrementiert bzw. wird in einen nächsten Schritt 44 eingetreten, in dem nunmehr wieder überprüft wird, ob die im letzten Wert vergrößerte oder, verkleinerte Frequenz wiederum zu hoch oder zu niedrig ist.

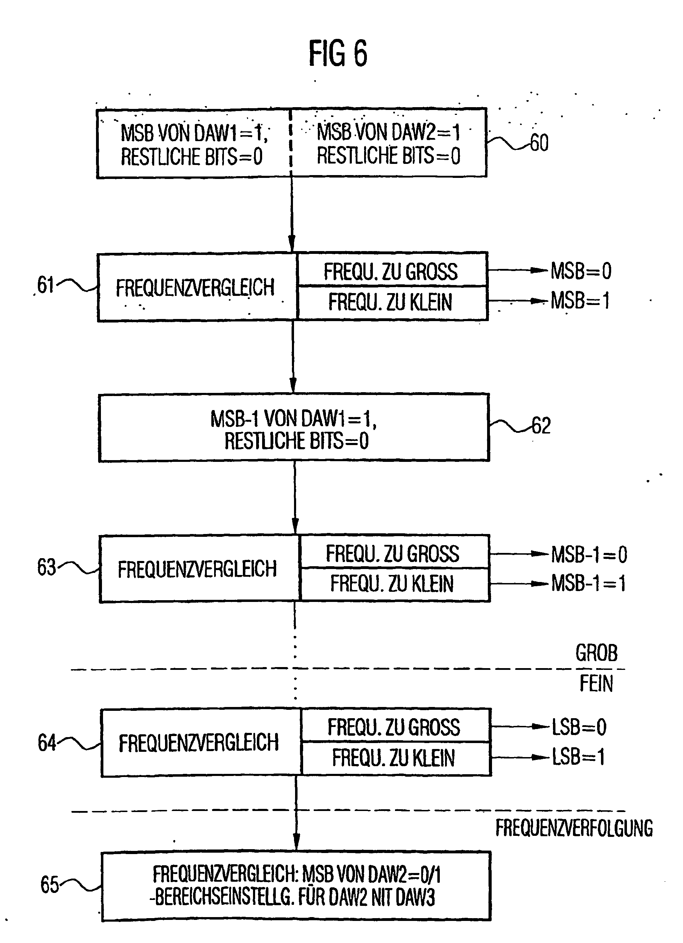

Als Iterationsstrategie bzw. als Inkrementwert, mit dem die Frequenz in einem Schritt zum nächsten erhöht bzw. erniedrigt wird, können verschiedene Strategien eingesetzt werden. Es wird bevorzugt, ein Konzept einzusetzen, bei dem der Inkrementbetrag, um den die Frequenz von einem Schritt zum nächsten verändert wird, also erhöht bzw. erniedrigt wird, sich von Schritt zu Schritt verändert und insbesondere sich von Schritt zu Schritt verkleinert. Hierzu wird es bevorzugt, ein Verfahren der sukzessiven Approximation einzusetzen, das später anhand der Fig. 6 näher erläutert wird.

Hier wird das 1 ms-Rahmenintervall zum Einstellen der Frequenz des freilaufenden Oszillators eingesetzt. Innerhalb von 10 Rahmenintervallen ist die Frequenzgenauigkeit des Oszillators innerhalb des spezifizierten Bereichs von 0,25%. Hierzu wird, wie es ausgeführt worden ist, eine Abstimmung des Oszillators in zwei Abschnitten durchgeführt, nämlich zunächst in einem Grobabstimmungsabschnitt und dann in einem Feinabstimmungsabschnitt.

Für die Grobeinstellung wird die Anzahl von Öszillatorperioden zwischen einer bestimmten Anzahl von SYNC-Feld-Bits gezählt und mit einem Referenzwert verglichen. Wenn der Zählerwert größer als der Referenzwert ist, ist die Oszillatorfrequenz zu hoch und wird verringert. Ist dagegen der Zählerwert kleiner als der Referenzwert, so ist die Oszillatorfrequenz zu niedrig und wird erhöht. Wenn die Anzahl von Grobabstimmungsschritten gleich C beträgt, wenn der Referenzwert mit CR bezeichnet ist und wenn der Zählerwert mit CC bezeichnet wird, und wenn schließlich die Frequenz des Oszillators ν beträgt, so kann der Grobabstimmungsalgorithmus folgendermaßen allgemein dargestellt werden:
1. Bestimmen von CC_{C}(ν_{C-1})
2. CC_{C} > CR : ν_{C} = ν_{C-1} - Δν_{C}
   CC_{C} < CR : ν_{C} = ν_{C-1} + Δν_{C} usw.
3. Bestimmen von CC_{C+1} (ν_{C})

Nach einer bestimmten kleinen Anzahl von Grobabstimmungsschritten kann die Messung auf der Basis von SYNC-Bits die Genauigkeit der Oszillatorfrequenz nicht weiter verbessern. Nun beginnt die Feinabstimmung.

Zur Feinabstimmung wird die Anzahl von Oszillatorperioden zwischen SOF-Paketen gezählt, und es wird ein Algorithmus, der ähnlich dem Grobabstimmungsalgorithmus ist, eingesetzt. Wenn die Feinabstimmungs-Schritt-Nummer F beträgt, der Referenzwert FR beträgt, der Zählerwert FC beträgt und die Frequenz des Oszillators wieder ν ist, ergibt sich der Feinabstimmungsalgorithmus folgendermaßen:
(a) Bestimmen von FC_{F}(ν_{F-1})
(b) FC_{F} > FR : ν_{F} = ν_{F-1} - Δν_{F}
   FC_{F} < FR : ν_{F} = ν_{F-1} + Δν_{F} usw.
(c) Bestimmen von FC_{F+1} (ν_{F})

Da die Zeit zwischen aufeinanderfolgenden SOF-Paketen auf ±500 ns genau ist, wird eine Genauigkeit der eingestellten Frequenz von 0,05% (500 ppm) erreicht.

Die Frequenz des Oszillators nach der Abstimmung desselben wird durch den Referenzwert FR bestimmt. Wenn die erwünschte Oszillatorfrequenz beispielsweise 96 MHz beträgt, muss der Referenzwert FR gleich 96.000 sein, wenn aufeinanderfolgende SOF-Pakete betrachtet werden. Werden nicht unmittelbar aufeinanderfolgende SOF-Pakete betrachtet, sondern z. B. zweifach, bzw. dreifach aufeinanderfolgende SOF-Pakete, so ist der Referenzwert entsprechend höher. Im Falle von Halben, Dritteln, Vierteln, ... der Periodendauer zwischen SOF-Paketen ist der Referenzwert entsprechend niedriger.

Das zweistufige erfindungsgemäße Konzept erlaubt es, eine einerseits schnelle und andererseits genaue Frequenzeinstellung zu erreichen. Für USB-Anwendungen existiert nur eine StartUp-Zeit von etwa 10 ms, in der ein neuer Kommunikationsteilnehmer bereit sein muss. Ist er in dieser Zeit nicht bereit, so gibt es ein Fehlersignal. Nur aufgrund der Feinabstimmung reicht diese Zeit normalerweise nicht aus, da es nur 10 aufeinanderfolgende SOF-PIDs in den 10 ms Startup-Zeit gibt.

Andererseits ist die Grobabstimmung allein zwar schnell, aber zu ungenau, da das Synchronisationsmuster zu ungenau im Datenstrom ist.

Erfindungsgemäß wird daher die Grobabstimmung z. B. mit dem ersten Synchronisationsmuster durchgeführt, so dass in der Startup-Zeit von 10 ms noch genug aufeinanderfolgende Ereignisse im Datenstrom (z. B. SOF-PIDs) verbleiben, dass eine sichere und genau Abstimmung des nunmehr grob abgestimmten Oszillators erreicht wird.

Wie es bereits anhand der Fig. 3 dargestellt worden ist, findet nach der Feinabstimmung ein Frequenzverfolgungsalgorithmus statt, der die Oszillatorfrequenz weiter einstellt. Wie im Feinabstimmungsalgorithmus wird die Anzahl von Oszillatorperioden zwischen im Datenstrom vorhandenen SOF-Paketen gemessen.

Der Oszillatortakt, der nach der Grobabstimmung und nach der Feinabstimmung erhalten wird, kann beispielsweise als Referenztakt für einen USB-Kern verwendet werden. Hierzu wird auf Fig. 8 verwiesen, in der die Vorrichtung zum Extrahieren, die mit 80 bezeichnet ist, dargestellt ist. Die Vorrichtung zum Extrahieren besitzt daher zusammen mit einem steuerbaren Oszillator die Funktionalität der Blöcke 92 und 93 der bekannten USB-Funktionsschaltung, die anhand von Fig. 9 erläutert worden ist.

Es sei darauf hingewiesen, dass ein Phasen-Locking zwischen dem Oszillatortakt und dem Bittakt des USB-Datenstroms nicht nötigt ist, da die Oszillatortaktfrequenz üblicherweise ein Vielfaches der Bittaktfrequenz ist und ein Oversampling und digitale PLLs zur Datenwiedergewinnung verwendet werden können.

Die Vorrichtung ist dahingehend vorteilhaft, dass für Datenströme, denen ein schneller Takt zugrunde liegt, wie z. B. für Full-Speed-USB-Datenströme und High-Speed-USB-Datenströme, kein Quarzoszillator benötigt wird. Natürlich werden auch für langsamer getaktete Datenströme keine externen Oszillatoren benötigt.

Die Vorrichtung ist ferner dahingehend vorteilhaft, da die regenerierte Frequenz mit hoher Genauigkeit erhalten wird, die durch die. Genauigkeit, bestimmt ist, mit der das erste Datenmuster im Datenstrom vorhanden ist. Am Beispiel der USB-Anwendung wird eine Genauigkeit von 0,05% erreicht.

Nachfolgend wird Bezug nehmend auf Fig. 5 ein Beispiel in Blockdiagrammform dargestellt. Fig. 5 zeigt eine Taktregenerationsschaltung, die prinzipiell aus zwei Haupteinheiten besteht. Die eine ist der digital steuerbare Oszillator 50, der eine Oszillatorsteuerung 11 einerseits und den steuerbaren Oszillator 10 andererseits aufweist, der in Fig. 5 ein stromgesteuerter Oszillator ist.

Fig: 5 zeigt ferner eine Digitallogik 52, die die Grobabstimmungseinrichtung 13 und die Feinabstimmungseinrichtung 14 umfasst, wie es nachfolgend dargestellt wird.

Der stromgesteuerte Oszillator 10 ist bei dem in Fig. 5 gezeigten bevorzugten Ausführungsbeispiel ein stromgesteuerter Ringoszillator mit einer ungeraden Anzahl von in Kette geschalteten Invertern 51a, 51b, 51c, die von einem Stromsummenknoten 52 mit einem Betriebsstrom versorgt werden, über den eine Schwingfrequenz des stromgesteuerten Oszillators 10 einstellbar ist.

Die Oszillatorsteuerungseinrichtung 11 umfasst neben dem Stromsummenknoten 52 eine Versorgungsstromquelle bzw. Referenzstromquelle 53, die eine zentrale Referenz liefert (es ist typischerweise zusätzlich ein eigenes Bias vorhanden), einen ersten Digital-Analog-Wandler 54, einen zweiten Digital-Analog-Wandler 55 und einen dritten Digital-Analog-Wandler 56. Die Digital-Analog-Wandler 54, 55 und 56 von Fig. 5 sind ausgebildet, um ausgangsseitig einen Strom zu liefern, der ein Bruchteil des eingangsseitig zugeführten Versorgungsstroms ist, wobei die Auswahl des Bruchteils über die dem Digital-Analog-Wandler über einen Digitaleingang zugeführte binäre Zahl erfolgt. Vorzugsweise werden binär-gewichtete Schaltungen. 54, 55 und 56 bevorzugt. Beispielsweise liefert der DAW. 1 (54) den Wert des Versorgungsstroms 53 an seinem Ausgang zum Stromsummationsknoten 52, wenn alle Bits der demselben zugeführten binären Zahl gesetzt sind. Ist dagegen nur das MSB des DAW 1 (54) gesetzt, während alle Bits mit niedriger Wertigkeit gleich 0 sind, so liefert der DAW 1 ausgangsseitig die Hälfte des von der Quelle 53 gelieferten Stroms zum Stromsummationsknoten. Erfindungsgemäß werden 9-Bit-DAWs bevorzugt, obgleich in der Ausführungsform auch DAWs mit höherer bzw. niedrigerer Breite eingesetzt werden können.

Es sei darauf hingewiesen, dass als Schwingungserzeugungseinrichtung auch voll differentielle Ringoszillatoren mit einer geraden Anzahl.von differentiellen Invertern eingesetzt werden können. In diesem Fall wird eine Phasenverschiebung von 180 Grad durch Vertauschen von N-Ausgang und P-Ausgang bei der Rückkopplung auf den Eingang erreicht.

Wie es aus Fig. 5 ersichtlich ist, wird der DAW 1 54 direkt von der Stromversorgung 53 versorgt. Er kann daher ausgangsseitig den maximalen Strombetrag liefern. Der DAW 1 wird bei einem bevorzugten Ausführungsbeispiel der vorliegenden Erfindung durch die Grobabstimmung und die Feinabstimmung eingestellt. Insbesondere werden die höherwertigen Bits des DAW 1 durch die Grobabstimmung eingestellt, während die niederwertigen Bits des DAW 1 durch die Feinabstimmung eingestellt werden. Der DAW 2 55 wird zur Frequenzverfolgung eingesetzt. Sein Versorgungsstrom und damit der von ihm maximal zum Stromsummationsknoten 52 lieferbare Oszillatorsteuerstrom ist durch den DAW 3 56 steuerbar. Wird der DAW 3 56 mit einem Binärwert, in dem alle Bits gesetzt sind, angesteuert, so ist der Ausgabestrom des DAW 3 56 gleich dem Versorgungsstrom 53, was unmittelbar dazu führt, dass der DAW 2, wenn er ebenfalls mit lauter Einsen beaufschlagt wird, denselben Strom zum Summationsknoten 52 liefern kann. Erfindungsgemäß wird es jedoch bevorzugt, den DAW 3 mit einer Binärzahl zu beaufschlagen, die kleiner als die maximal beaufschlagbare Binärzahl ist, um den Maximalstrom, der durch den DAW 2 55.zum Stromsummationsknoten 52. geliefert wird, zu, verringern. Dieser verringerte Maximalstrom ist dann aufgrund der Tatsache, dass der DAW 2 55 ebenfalls beispielsweise mit 9 Bits beaufschlagt werden kann, feiner unterteilbar, um eine Frequenzverfolgung, zu der der DAW 2 55 eingesetzt wird, mit einer feineren Genauigkeit durchführen zu können, wie sie durch das LSB des DAW 1 bestimmt ist. Allgemein gesagt ist die Granularität des Stroms, der durch den DAW 2 ausgegeben wird, umgekehrt proportional zu dem dem DAW 2 zugeführten Betriebsstrom. Je kleiner der Betriebsstrom ist, der dem DAW 2 zugeführt wird (eingestellt durch den DAW 3), um so feiner ist die Granularität im Frequenzverfolgungsmodus, der auf den Feinabstimmuhgsmodus folgt.

Der digital steuerbare Oszillator 11 umfasst somit eine Versorgungsquelle 53, den stromgesteuerten Ringoszillator 10 und die drei DAWs 54, 55 und 56. Die DAWs, die durch die Digitallogik 52 gesteuert werden, liefern den Steuerstrom zur Frequenzeinstellung des stromgesteuerten Oszillators ICO 10. Der Gesamtstrom für den ICO ist die Summe der Ströme, die von den beiden DAWs 54 und 55 geliefert werden. Die Bereiche der Digital-Analog-Wandler 1 und 2 sind vorzugsweise überlappend. Es wird bevorzugt, dass der maximale Ausgangsstrom des DAW 1 ein programmierbares Vielfaches (programmierbar durch den DAW 3) der maximalen Ausgabe des DAW 2 ist. Vorzugsweise wird ein Faktor 4 eingesetzt.

An dieser Stelle sei ferner darauf hingewiesen, dass während des Grobabstimmungsmodus und des Feinabstimmungsmodus der DAW 3 56 derart beaufschlagt wird, dass der Versorgungsstrom in dem DAW 2 um das programmierbare Vielfache kleiner ist als der Versorgungsstrom in dem DAW 1. Darüber hinaus wird bevorzugt, dass während der Grobabstimmung und der Feinabstimmung das MSB des DAW 2 gesetzt ist und/oder alle anderen Bits nicht gesetzt sind. Der DAW 2 liefert damit die Hälfte des von ihm insgesamt möglichen maximalen Ausgangsstroms zum Stromsummationsknoten 52. Sind dann alle Bits des DAW durch den Grobabstimmungsmodus und den Feinabstimmungsmodus eingestellt, so kann durch zusätzliches Setzen von Bits des DAW 2, die eine kleinere Wertigkeit haben als das MSB desselben, der Strom vergrößert.werden. Soll der Strom im Feinabstimmungsmodus dagegen verringert werden, so wird das MSB des DAW 2 rückgesetzt und es Werden je nach Bedarf die Bits niedrigerer Ordnung gesetzt oder nicht gesetzt. Dadurch, dass während des Grobabstimmungsmodus und des Feinabstimmungsmodus das MSB des DAW 2 gesetzt ist, wird sichergestellt, dass im Frequenzverfolgungsmodus, der auf den Feinabstimmungsmodus folgt, der Versorgungsstrom für den stromgesteuerten Oszillator sowohl erhöht als auch verringert werden kann.

Die Digitallogik 52 in Fig. 5 umfasst folgende grundsätzliche Funktionsblöcke. Zunächst umfasst die Schaltung einen Synchronisationsfelddetektor 520, der in Fig. 5 auch mit SD bezeichnet ist. Die Digitallogik umfasst ferner einen Datenwiederherstellungsblock 521, einen Rahmenstart-Paketidentifikationsdetektor (SOF-PID-Detektor) 522, einen Oszillatortaktzykluszähler 523, eine Digitaloszillatorsteuerlogik 524, die in Fig. 5 auch mit Korrekturwert-Erzeugungs-Einrichtung bezeichnet ist, und ferner einen Block 525, der mit Taktweiterleitungslogik und Takt-Teiler/Vervielfacher bezeichnet ist.

Der Synchronisationsfelddetektor 520 umfasst einen SEO-Detektor, einen Synchronisationsdetektor, eine Zustandsmaschine sowie einen eigenen Zähler. Der Block 520 ist mit den Differenz-Signalen Dp und Dm des USB-Busses verbunden. Der Block 520 ist wirksam, um Signale auf dem Bus abzuhören und damit den Busverkehr zu überwachen, um unter Verwendung des SE0-Detektors bestimmte Busbedingungen, wie z. B. das Vorliegen von "Single Ended Zero" zu erfassen. Im SE0-Modus sind sowohl Dp als auch Dm auf demselben Zustand, wie z. B. hoch. Nachdem Dp und Dm per Definition eigentlich Differenzsignale sind, ist der SE0-Zustand eigentlich ein verbotener Zustand, der keine aussagefähigen Nutzdaten enthält. Gemäß der USB-Spezifikation wird ein Zustand SE0 jedoch dann eingesetzt, wenn das Ende eines Pakets erreicht ist. Der SE0-Detektor erfasst somit das Ende eines vorausgehenden Pakets und damit auch den Beginn eines Synchronisationsfelds, das der Synchronisationsdetektor dann ansprechend auf den SE0-.Detektor detektiert. Nachdem eine SE0-Bedihgung im Block 520 erfasst worden ist, wird die Zustandsmaschine im Block 520 aktiviert, um auf den Empfang eines Synchronisationsmusters, wie es in Fig. 7a dargestellt ist, zu warten. Der Zähler im Block 520 misst die Länge des Synchronisationsmusters durch Zählen der Anzahl von Oszillatorperioden zwischen dem Beginn und dem Ende des Synchronisationsfeldes.

Der Data-Recovery-Block 521 wird durch den Block 520 über die mit EN bezeichnete Leitung aktiviert oder "enabled", nachdem der Block 520 ein gültiges Synchronisationsmuster empfangen hat. Die Data-Recovery-Einheit 521 wird wieder deaktiviert, wenn der Block 520 einen Zustand SE0 empfangen hat. Darüber hinaus wird das Meßergebnis vom Block 520 bezüglich der Länge des Synchronisationsfeldes dem Block 521 zugeführt, der diese Information dazu verwendet, um "Nullen" und "Einsen" aus dem seriellen USB-Datenstrom zu extrahieren, also den Datenstrom zu decodieren bzw. in dem Datenstrom enthaltene Informationen wiederzugewinnen. Immer wenn eine gültige "0" oder eine gültige "1" von dem Block 521 erkannt worden ist, wird diese an dem Ausgang des Blocks 521 signalisiert, derart, dass der Block 521 eine Folge von Nullen bzw. Einsen liefert.

Der Rahmenstart-Paketidentifikations-Detektor 521, der auch als SOF-Token-Detektor bezeichnet wird, untersucht den seriellen Datenstrom vom Block 521 und signalisiert dem Zähler 523, wenn er eine Rahmenstart-Paketidentifikationsnummer (SOF-PID) erfasst hat.

Der Oszillatortaktzykluszähler 523 zählt die Anzahl der DCO-Perioden zwischen dem Empfang aufeinanderfolgenden SOF-Tokens. Darüber hinaus umfasst der Zähler 523 eine Plausibilitätsüberprüfungseinrichtung, die untersucht, ob SOF-Tokens verfehlt worden sind. Die Plausibilitätsüberprüfungseinrichtung ist ausgebildet, um einen groben Zählwert mit einem aktuellen Zählwert zu vergleichen. Übersteigt der aktuelle Zählwert den groben zählwert um einen sehr hohen Betrag, so deutet dies darauf hin, dass wenigstens eine SOF-PID zwischen zwei erfassten SOF-PIDs verfehlt worden ist. In diesem Fall wird der Zähler 523 dahingehend gesteuert, dass dieser Zählwert nicht der Einrichtung 524 zur Verfügung gestellt wird, da dies zu einer starken Fehleinstellung des steuerbaren Oszillators führen würde. Statt dessen wird dieser Zählwert als nicht plausibel markiert und verworfen.

Die Korrekturwert-Erzeugungs-Einrichtung 524 führt die Frequenzabstimmung und Frequenzverfolgung durch. Nach einem Reset ist der Frequenzabstimmungsalgorithmus aktiv. Zunächst wird die Frequenz des Oszillators grob abgestimmt. Zur Grobabstimmung wird die Zyklusanzahl des Synchronisationsmusters verwendet, die durch den Block 520 gemessen worden ist. Die Grobabstimmung bestimmt die höchstwertigen Bits des DAW 1, wie es ausgeführt worden ist. Mit jedem Abstimmschritt werden die niederwertigen Bits nach und nach bestimmt. Nach einer bestimmten Anzahl C von Grobabstimmungsschritten, wobei bei einer Bitbreite des DAW 1 von 9 drei Schritte für die Grobabstimmung bevorzugt werden, startet der Feinabstimmungsalgorithmus aktiviert durch eine in Fig. 1 dargestellte Steuerungseinrichtung, die die Schrittfolge der Grobabstimmung, Feinabstimmung und Frequenzverfolgung prinzipiell steuert.

Wenn die Breite des DAW 1 D1 Bits beträgt, beträgt die Anzahl der Feinabstimmungsschritte D1 - C.

Wie es ausgeführt worden ist, findet nach der Feinabstimmung die Frequenzverfolgung statt. Wie beim Feinabstimmungsalgorithmus wird auch bei der Frequenzverfolgung der Zykluszählwert des Zählers 521 eingesetzt, um die Oszillatorfrequenz über den DAW 2 55 weiter einzustellen.

Nachfolgend wird auf Fig. 6 Bezug genommen, um die Funktionalität der Korrekturwert-Erzeugungs-Einrichtung 524 detaillierter darzustellen.

In einem ersten Schritt 60 wird das höchstwertige Bit des DAW 1 gleich 1 gesetzt, während die restlichen Bits auf 0 gesetzt werden. Das MSB des DAW 2 wird während der ganzen Grob- und Feinabstimmung ebenfalls gesetzt, während die restlichen Bits des DAW 2 gleich 0 sind. In einem Schritt 61 führt die Einrichtung 524 anhand der Eingabewerte des Blocks SD 520 für die Grobabstimmung oder des Zählers 523 für die Feinabstimmung einen Frequenzvergleich durcti. Ist die Frequenz, zu groß, wird das MSB des DAW 1 gleich 0 gesetzt. Ist die Frequenz dagegen zu klein, bleibt das MSB des DAW 1 auf 1. Dann ist die Einrichtung 524 wirksam, um in einem Schritt 62 nunmehr das MSB-1 des DAW 1 zu setzen, nachdem das MSB derart ist, wie es im Schritt 61 bestimmt worden ist.

In einem Schritt 63 ist die Einrichtung 524 wieder wirksam, um einen Frequenzvergleich durchzuführen. Ist die Frequenz zu groß, so wird das Bit MSB-1 des DAW 1 auf 0 zurückgesetzt. Ist die Frequenz dagegen zu klein, so bleibt das Bit MSB-1 des DAW 1 auf seinem gesetzten Wert, d. h. auf 1. Auf diese Art und Weise der sukzessiven iterativen Approximation wird fortgeschritten, bis eine entsprechende vorbestimmte Anzahl von Bits des DAW 1 gesetzt ist. Dann wird durch die Steuerung 15 von Fig. 1 die Korrekturwert-Erzeugurigs-Einrichtung 524 aktiviert, um vom Grobabstimmungsmodus in den Feinabstimmungsmodus zu gehen und nunmehr nicht mehr aufgrund der Zählwerte des Blocks 520 sondern aufgrund der Zählwerte des Blocks 523 zu arbeiten, um im Feinabstimmungsmodus die restlichen Bits des DAW 1 nach und nach zu berechnen.

Wenn schließlich alle Bits des DAW 1 berechnet sind (64), wird in den Frequenzverfolgungsmodus (65) geschaltet, in dem die Bits des DAW 2 entsprechend eingestellt werden. Wird im letzten Schritt 64 des Feinabstimmungsmodus festgestellt, dass die Frequenz zu klein war, so deutet dies darauf hin, dass das MSB des DAW 2, das zu Anfang im Schritt 60 auf 1 gesetzt wurde, zu Recht auf 1 ist. Wird dagegen im letzten Schritt 64 des Feinabstimmungsmodus festgestellte dass die Frequenz zu groß ist, so wird das MSB des DAW 2 auf 0 gesetzt und die sukzessive Approximation mit dem MSB -1 des DAW. 2 nach und nach durchgeführt. Je nach Ausführungsform kann zu bestimmten Zeitpunkten der DAW 3 umprogrammiert werden, um den Maximalausgabestrom und damit die Granularität des DAW 2 einzustellen bzw. an sich wechselnde Gegebenheiten anzupassen.

### Bezugszeichenliste

- 10: steuerbarer Oszillator
- 11: Oszillatorsteuerung
- 12a: Grobabstimmungsleitung
- 12b: Feinabstimmungsleitung
- 13: Grobabstimmungseinrichtung
- 14: Feinabstimmungseinrichtung
- 15: Gesamtsteuerung
- 40: Messen der Anzahl von Taktzyklen
- 41: Vergleichen mit einem Referenzwert
- 42: Frequenzverkleinern
- 43: Frequenzvergrößern
- 44: nächster Schritt
- 50: digital steuerbarer Oszillator
- 51a: erster Inverter
- 51b: zweiter Inverter
- 51c: dritter Inverter
- 52: Stromsummationsknoten
- 53: Versorgungsquelle
- 54: Digital-Analog-Wandler 1
- 55: Digital-Analog-Wandler 2
- 56: Digital-Analog-Wandler 3
- 60: MSB von DAW 1 setzen
- 61: Frequenzvergleich
- 62: MSB -1 von DAW 1 setzen
- 63: Frequenzvergleich
- 64: Frequenzvergleich im Feinabstimmungsmodus
- 65: Frequenzvergleich im Frequenzverfolgungsmodus
- 72: erster Rahmen
- 73: zweiter Rahmen
- 74: ein ms-Ticks
- 75: PID
- 76: Rahmenzahl
- 77: Fingerabdruck der Rahmenzahl
- 80: Vorrichtung zum Extrahieren
- 90: USB-Frontend
- 91: USB-Kern
- 92: Quarzoszillator
- 93: Quarzoszillatorbeschreibung
- 94: Taktverteilung
- 95: CPU
- 96: Speicher
- 97: Parallel-I/O-Schnittstelle
- 130: Einrichtung zum Erfassen
- 131: Einrichtung zum Zählen
- 132: Einrichtung zum Vergleichen
- 140: Einrichtung zum Erfassen
- 141: Einrichtung zum Zählen
- 142: Einrichtung zum Vergleichen
- 501: analoges Eingangssignal
- 502: erstes DAW-Ausgangssignal
- 503: erstes digitales Eingangssignal
- 504: zweites DAW-Ausgangssignal
- 505: zweites digitales Eingangssignal
- 506: Versorgungssignal für DAW3
- 507: Versorgungssignal für DAW2
- 508: drittes digitales Eingangssignal
- 520: Synchronisationsdetektorblock
- 521: Datenwiederherstellungsblock
- 522: Rahmenstart-Paketidentifikations-Detektor
- 523: Feinabstimmungs-Zähler
- 524: Korrekturwert-Erzeugungs-Einrichtung
- 525: Taktweiterleitungslogik/Takt-Teiler/Vervielfacher

## Patentansprüche

1. Digital steuerbarer Oszillator mit folgenden Merkmalen:
einer Schwingungserzeugungseinrichtung (10), die ausgebildet ist, um eine Schwingung zu erzeugen, die eine Frequenz hat, die über ein analoges Eingangssignal (501) in die Schwingungserzeugungseinrichtung (10) einstellbar ist; und
eine Oszillatorsteuerung (11), zum Erzeugen des analogen Eingangssignals (501), wobei die Oszillatorsteuerung folgende Merkmale aufweist:
einen ersten Digital/Analog-Wandler (54) zum Liefern eines ersten Digital/Analog-Wandler-Ausgangssignals (502) ansprechend auf ein erstes digitales Eingangssignal (503);
einen zweiten Digital/Analog-Wandler (55) zum Liefern eines zweiten Digital/Analog-Wandler-Ausgangssignals ansprechend auf ein zweites digitales Eingangssignal (505); und
einen Kombinierer (52) zum Kombinieren des ersten und des zweiten Digital/Analog-Wandler-Ausgangssignals (502, 504), um das analoge Eingangssignal (501) für die Schwingungserzeugungseinrichtung (10) zu erhalten,
wobei der zweite Digital/Analog-Wandler (55) ausgebildet ist, um ansprechend auf ein digitales Inkrement in dem zweiten digitalen Eingangssignal (505) eine Differenz in dem zweiten Digital/Analog-Wandler-Ausgangssignal (504) zu liefern, das kleiner ist als eine Differenz in dem ersten Digital/Analog-Wandler-Ausgangssignal (502), wenn der erste Digital/Analog-Wandler (54) mit dem digitalen Inkrement in dem ersten digitalen Eingangssignal (503) beaufschlagt wird,
wobei der erste Digital/Analog-Wandler (54) und/oder der zweite Digital/Analog-Wandler (55) ausgebildet sind, um ansprechend auf ein digitales Inkrement eine Differenz in dem ersten bzw. dem zweiten Ausgangssignal zu liefern, das von einer Versorgungsgröße für den Digital/Analog-Wandler abhängt,
wobei die Versorgungsgröße für den zweiten Digital/Analog-Wandler (55) sich von einer Versorgungsgröße für den ersten Digital/Analog-Wandler (54) unterscheidet,
**dadurch gekennzeichnet, dass**
die Oszillatorsteuerung einen dritten Digital/Analog-Wandler (56) aufweist, der mit dem zweiten Digital/Analog-Wandler so verschaltet ist, dass er die Versorgungsgröße (507) für den zweiten Digital/Analog-Wandler liefert, wobei die Versorgungsgröße (507) für den zweiten Digital/Analog-Wandler über ein digitales Eingangssignal (508) in den dritten Digital/Analog-Wandler einstellbar ist.

2. Digital steuerbarer Oszillator nach Anspruch 1, bei dem der erste Digital/Analog-Wandler (54) und/oder der zweite Digital/Analog-Wandler (55) ausgebildet sind, um ansprechend auf ein digitales Inkrement eine Differenz in dem ersten bzw. dem zweiten Ausgangssignal zu liefern, die von einer Versorgungsgröße (506, 507) für den Digital/Analog-Wandler abhängt.

3. Digital steuerbarer Oszillator nach Anspruch 1, bei dem die Oszillatorsteuerung (11) ferner folgendes Merkmal aufweist:
eine Versorgungsquelle (53) zum Liefern einer Versorgungsgröße (506), und
bei der der erste und der dritte Digital/Analog-Wandler (54, 56) von der Versorgungsquelle mit der gleichen Versorgungsgröße (506) versorgt werden, und
bei dem der zweite Digital/Analog-Wandler (55) mit einer Versorgungsgröße (507) versorgt wird, die kleiner ist als die Versorgungsgröße (506) für den ersten und den dritten Digital/Analog-Wandler, wobei die Versorgungsgröße für den zweiten Digital/Analog-Wandler durch das digitale Eingangssignal (508) in den dritten Digital/Analog-Wandler einstellbar ist.

4. Digital steuerbarer Oszillator nach Anspruch 1 oder 3, bei dem der erste, der zweite und der dritte Digital/Analog-Wandler identisch ausgebildet sind.

5. Digital steuerbarer Oszillator nach einem der Ansprüche 1, 3, bei dem der erste, der zweite und der dritte Digital/Analog-Wandler auf einer Schaltung integriert sind.

6. Digital steuerbarer Oszillator nach einem der vorhergehenden Ansprüche,
bei der die Schwingungserzeugungseinrichtung (10) eine ungerade Anzahl von Invertern (51a, 51b, 51c) aufweist, die in einem Ring geschaltet sind, wobei die Inverter durch das analoge Eingangssignal (501) versorgbar sind.

7. Digital steuerbarer Oszillator nach einem der vorhergehenden Ansprüche, bei dem das erste und das dritte Digital/Analog-Wandler-Ausgangssignal und das analoge Eingangssignal ein Strom sind.

8. Digital steuerbarer Oszillator nach einem der vorhergehenden Ansprüche, bei dem das digitale Inkrement eine Veränderung eines binären Worts, das dem ersten und dem zweiten Digital/Analog-Wandler als Eingangssignale (503, 505) zuführbar sind, um ein Bit umfasst.

9. Digital steuerbarer Oszillator nach einem der vorhergehenden Ansprüche,
bei dem der erste Digital/Analog-Wandler in einem Abstimmungsmodus ansteuerbar ist, und bei dem der zweite Digital/Analog-Wandler in einem Frequenzverfolgungsmodus ansteuerbar ist,
wobei in dem Frequenzverfolgungsmodus der erste Digital/Analog-Wandler mit einem konstanten digitalen Eingangssignal (503) beaufschlagt ist, und
wobei in dem Abstirmnungsmodus der zweite Digital/Analog-Wandler mit einem konstanten zweiten digitalen Eingangssignal (505) beaufschlagt ist.

10. Digital steuerbarer Oszillator nach Anspruch 10, bei dem das zweite digitale Eingangssignal (505) in den zweiten Digital/Analog-Wandler in dem Abstimmungsmodus derart gewählt ist, dass nach Abschluß des Abstimmungsmodus in dem Frequenzverfolgungsmodus durch Ändern des digitalen Eingangssignals in den zweiten Digital/Analog-Wandler das analoge Eingangssignal (501) in die Schwingungserzeugungseinrichtung (10) zu größeren und zu kleineren Werten veränderbar ist.

11. Digital steuerbarer Oszillator nach Anspruch 9 oder 10,
bei dem der zweite Digital/Analog-Wandler (55) in dem Abstimmungsmodus, in dem der erste Digital/Analog-Wandler variabel ansteuerbar ist, mit einem digitalen Eingangssignal beaufschlagt ist, in dem ein höchstwertiges Bit gesetzt ist und sämtliche niederwertigen Bits nicht gesetzt sind, so dass das zweite Digital/Analog-Wandler-Ausgangssignal (504) eine Größe hat, die in etwa bei der Hälfte einer Größe des maximal erreichbaren Ausgangssignals des zweiten Digital/Analog-Wandlers (55) ist.

12. Digital steuerbarer Oszillator nach einem der vorhergehenden Ansprüche, bei dem der erste (54) und/oder der zweite Digital-Analog-Wandler (55) eingangsseitig mit einer binären Zahl einer Breite von n Bits beaufschlagbar ist,
wobei der erste und/oder der zweite Digital-Analog-Wandler mit einer elektrischen Eingangsgröße (53) versorgbar ist,
wobei eine von dem Digital-Analog-Wandler ausgangsseitig gelieferte Steuergröße dem Kombinierer zuführbar ist, und
wobei ein Betrag der elektrischen Steuergröße gleich einem Verhältnis ist, das durch die binäre Zahl und die elektrische Eingangsgröße festgelegt ist.

## Claims

1. Digitally controllable oscillator, comprising:
an oscillation generator (10) implemented to generate an oscillation having a frequency settable via an analog input signal (501) into the oscillation generator (10); and
an oscillator control (11) for generating the analog input signal (501), wherein the oscillator control comprises:
a first digital/analog converter (54) for providing a first digital/analog converter output signal (502) in response to a first digital input signal (503);
a second digital/analog converter (55) for providing a second digital/analog converter output signal in response to a second digital input signal (505); and
a combiner (52) for combining the first and the second digital/analog converter output signals (502, 504) in order to obtain the analog input signal (501) for the oscillation generator (10),
wherein the second digital/analog converter (55) is implemented in order to provide, in response to a digital increment in the second digital input signal (505), a difference in the second digital/analog converter output signal (504) which is smaller than a difference in the first digital/analog converter output signal (502), when the first digital/analog converter (54) is pulsed with the digital increment in the first digital input signal (503),
wherein the first digital/analog converter (54) and/or the second digital/analog converter (55) are implemented in order to provide, in response to a digital increment, a difference in the first or the second output signal, respectively, depending on a supply quantity for the digital/analog converter,
wherein the supply quantity for the second digital/analog converter (55) is different from a supply quantity for the first digital/analog converter (54),
**characterized in that** the oscillator control comprises a third digital/analog converter (56) connected to the second digital/analog converter so that it provides the supply quantity (507) for the second digital/analog converter, wherein the supply quantity (507) for the second digital/analog converter is settable via a digital input signal (508) into the third digital/analog converter.

2. Digitally controllable oscillator according to claim 1, wherein the first digital/analog converter (54) and/or the second digital/analog converter (55) are implemented in order to provide, in response to a digital increment, a difference in the first or the second output signal, respectively, depending on a supply quantity (506, 507) for the digital/analog converter.

3. Digitally controllable oscillator according to claim 1, wherein the oscillator control (11) further comprises:
a supply source (53) for supplying a supply quantity (506), and
wherein the first and the third digital/analog converters (54, 56) are provided by the supply source with the same supply quantity (506), and
wherein the second digital/analog converter (55) is supplied with a supply quantity (507) smaller than the supply quantity (506) for the first and the third digital/analog converters, wherein the supply quantity for the second digital/analog converter is settable by the digital input signal (508) into the third digital/analog converter.

4. Digitally controllable oscillator according to claim 1 or 3, wherein the first, the second and the third digital/analog converters are implemented identically.

5. Digitally controllable oscillator according to one of claims 1, 3, wherein the first, the second and the third digital/analog converters are integrated on a circuit.

6. Digitally controllable oscillator according to one of the preceding claims,
wherein the oscillation generator (10) comprises an odd number of inverters (51a, 51b, 51c) connected in a ring, wherein the inverters may be supplied by the analog input signal (501).

7. Digitally controllable oscillator according to one of the preceding claims, wherein the first and the third digital/analog converter output signal and the analog input signal are a current.

8. Digitally controllable oscillator according to one of the preceding claims, wherein the digital increment includes a change of a binary word, that may be supplied to the first and the second digital/analog converters as input signals (503, 505), by one bit.

9. Digitally controllable oscillator according to one of the preceding claims,
wherein the first digital/analog converter is controllable in a tuning mode and wherein the second digital/analog converter is controllable in a frequency-tracking mode,
wherein in the frequency-tracking mode the first digital/analog converter is pulsed with a constant digital input signal (503), and
wherein in the tuning mode the second digital/analog converter is pulsed with a constant second digital input signal (505).

10. Digitally controllable oscillator according to claim 10, wherein the second digital input signal (505) in the second digital/analog converter in the tuning mode is selected so that after terminating the tuning mode in the frequency-tracking mode by changing the digital input signal in the second digital/analog converter the analog input signal (501) may be changed in the oscillation generator (10) into larger and into smaller values.

11. Digitally controllable oscillator according to claim 9 or 10,
wherein the second digital/analog converter (55) in the tuning mode in which the first digital/analog converter is controllable in a variable way is pulsed with a digital input signal in which a most significant bit is set and any low-order bits are not set so that the second digital/analog converter output signal (504) has a quantity which is about half of a quantity of the maximum obtainable output signal of the second digital/analog converter (55).

12. Digitally controllable oscillator according to one of the preceding claims, wherein the first (54) and/or the second digital/analog converter (55) may be pulsed on the input side with a binary number of a width of n bits,
wherein the first and/or the second digital/analog converter may be supplied with an electric input quantity (53),
wherein a control quantity supplied on the output side by the digital/analog converter may be supplied to the combiner, and
wherein an amount of the electric control quantity is equal to a ratio determined by the binary number and the electric input quantity.

## Revendications

1. Oscillateur à commande numérique ayant les caractéristiques suivantes :
un dispositif (10) de génération d'oscillations, qui est formé pour générer une oscillation, qui a une fréquence, qui peut être réglée dans le dispositif (10) de génération d'oscillations par l'intermédiaire d'un signal (501) d'entrée analogique ; et
une commande (11) de l'oscillateur pour générer le signal (501) d'entrée analogique, la commande de l'oscillateur présentant les caractéristiques suivantes :
un premier convertisseur (54) numérique/analogique pour fournir un premier signal (502) de sortie du convertisseur numérique/analogique en réponse à un premier signal (503) d'entrée numérique ;
un deuxième convertisseur (55) numérique/analogique pour fournir un deuxième signal de sortie du convertisseur numérique/analogique en réponse à un deuxième signal (505) d'entrée numérique ; et
un combinateur (52) pour combiner le premier et le deuxième signal (502, 504) de sortie du convertisseur numérique/analogique, afin d'obtenir le signal (501) d'entrée analogique pour le dispositif (10) de génération d'oscillations,
le deuxième convertisseur (55) numérique/analogique étant formé, pour fournir une différence dans le deuxième signal (504) de sortie du convertisseur numérique/analogique en réponse à un incrément numérique dans le deuxième signal (505) d'entrée numérique, qui est inférieure à une différence dans le premier signal (502) de sortie du convertisseur numérique/analogique, lorsque le premier convertisseur (54) numérique/analogique ayant l'incrément numérique est injecté dans le premier signal (503) d'entrée numérique,
le premier convertisseur (54) numérique/analogique et/ou le deuxième convertisseur (55) numérique/analogique étant formés pour fournir une différence dans le premier ou dans le deuxième signal de sortie en réponse à un incrément numérique, signal de sortie qui dépend d'une grandeur d'alimentation pour le convertisseur numérique/analogique,
la grandeur d'alimentation pour le deuxième convertisseur (55) numérique/analogique se différenciant d'une grandeur d'alimentation pour le premier convertisseur (54) numérique/analogique,
**caractérisé en ce que**
la commande de l'oscillateur présente un troisième convertisseur (56) numérique/analogique, qui est câblé avec le deuxième convertisseur numérique/analogique de telle sorte qu'il fournisse la grandeur (507) d'alimentation pour le deuxième convertisseur numérique/analogique, la grandeur (507) d'alimentation pour le deuxième convertisseur numérique/analogique pouvant être réglée dans le troisième convertisseur numérique/analogique par l'intermédiaire d'un signal (508) d'entrée numérique.

2. Oscillateur à commande numérique suivant la revendication 1, pour lequel le premier convertisseur (54) numérique/analogique et/ou le deuxième convertisseur (55) nuémrique/analogique sont formés pour fournir une différence dans le premier ou dans le deuxième signal de sortie en réponse à un incrément numérique, signal de sortie qui dépend d'une grandeur (506, 507) d'alimentation pour le convertisseur numérique/analogique.

3. Oscillateur à commande numérique suivant la revendication 1, pour lequel la commande (11) de l'oscillateur présente en outre la caractéristique suivante :
une source (53) d'alimentation pour fournir une grandeur (506) d'alimentation, et
pour lequel le premier et le troisième convertisseur (54, 56) numérique/analogique sont alimentés par la source d'alimentation ayant la même grandeur (506) d'alimentation, et
pour lequel le deuxième convertisseur (55) numérique/analogique est alimenté par une grandeur (507) d'alimentation, qui est inférieure à la grandeur (506) d'alimentation pour le premier et le troisième convertisseur numérique/analogique, la grandeur d'alimentation pour le deuxième convertisseur numérique/analogique pouvant être réglée par le signal (508) d'entrée numérique dans le troisième convertisseur numérique/analogique.

4. Oscillateur à commande numérique suivant la revendication 1 ou 3, pour lequel le premier, le deuxième et le troisième convertisseur numérique/analogique sont formés de façon identique.

5. Oscillateur à commande numérique suivant la revendication 1 ou 3, pour lequel le premier, le deuxième et le troisième convertisseur numérique/analogique sont intégrés dans un circuit.

6. Oscillateur à commande numérique suivant l'une des revendications précédentes,
pour lequel le dispositif (10) de génération d'oscillations présente un nombre impair d'inverseurs (51a, 51b, 51c), qui sont montés sur un anneau, les inverseurs pouvant être alimentés par le signal (501) d'entrée analogique.

7. Oscillateur à commande numérique suivant l'une des revendications précédentes, pour lequel le premier et le troisième signal de sortie du convertisseur numérique/analogique et le signal d'entrée analogique sont un courant.

8. Oscillateur à commande numérique suivant l'une des revendications précédentes, pour lequel l'incrément numérique comprend une modification d'un mot binaire, qui peuvent être livrés au premier et au deuxième convertisseur numérique/analogique en tant que signaux (503, 505) d'entrée, d'un bit.

9. Oscillateur à commande numérique suivant l'une des revendications précédentes,
pour lequel le premier convertisseur numérique/analogique peut être amorcé dans un mode d'accord, et pour lequel le deuxième convertisseur numérique/analogique peut être amorcé dans un mode de poursuite en fréquence,
le premier convertisseur numérique/analogique ayant un signal (503) d'entrée numérique constant pouvant être injecté dans le mode de poursuite en fréquence, et
le deuxième convertisseur numérique/analogique ayant un deuxième signal (505) d'entrée numérique constant pouvant être injecté dans le mode d'accord.

10. Oscillateur à commande numérique suivant la revendication 9, pour lequel le deuxième signal (505) d'entrée numérique dans le deuxième convertisseur numérique/analogique dans le mode d'accord est choisi de telle sorte qu'à la fin du mode d'accord le signal (501) d'entrée analogique peut être modifié dans le dispositif (10) de génération d'oscillations pour obtenir des valeurs plus grandes et plus petites en modifiant le signal d'entrée numérique dans le deuxième convertisseur numérique/analogique dans le mode de poursuite en fréquence.

11. Oscillateur à commande numérique suivant la revendication 9 ou 10,
pour lequel le deuxième convertisseur numérique/analogique est injecté avec un signal d'entrée numérique dans le mode d'accord, dans lequel le premier convertisseur numérique/analogique peut être amorcé de façon grandeur, dans lequel un bit de la plus grande valeur possible est mis et tous les bits de moindre valeur ne sont pas mis de telle sorte que le deuxième signal (504) de sortie du convertisseur numérique/analogique a une grandeur, qui est à peu près égale à la moitié d'une grandeur du signal de sortie, qui peut être atteint au maximum, du deuxième convertisseur (55) numérique/analogique.

12. Oscillateur à commande numérique suivant l'une des revendications précédentes, pour lequel le premier (54) et/ou le deuxième (55) convertisseur numérique/analogique peuvent être injectés du côté de l'entrée avec un nombre binaire d'une largeur de n bits,
le premier et/ou le deuxième convertisseur numérique/analogique pouvant être alimenté par une grandeur (53) d'entrée électrique,
une grandeur de commande fournie du côté de la sortie par le convertisseur numérique/analogique pouvant être livrée au combinateur, et
une somme de la grandeur de commande électrique étant égale à un rapport, qui est fixé par le nombre binaire et la grandeur d'entrée électrique.
